# EUROPEAN PATENT APPLICATION

(11) **EP 4 648 571 A1**
(43) Date of publication of application: **12.11.2025**
(21) Application number: 24756016.2
(22) Date of filing: 01.02.2024
(51) Int. Cl.: H05K 7/20, H01L 23/427, F28D 15/04

(54) **HEAT DISSIPATION DEVICE AND ELECTRONIC DEVICE**

(30) Priority: 13.02.2023 CN 202310106348
(71) Applicant: ZTE CORPORATION, Shenzhen, Guangdong 518057 (CN)
(72) Inventor: BAI, Hongwei, Shenzhen, Guangdong 518057 (CN); SUN, Zhen, Shenzhen, Guangdong 518057 (CN); DUAN, Zhiwei, Shenzhen, Guangdong 518057 (CN); XU, Qingsong, Shenzhen, Guangdong 518057 (CN)
(74) Representative: Ziebig Hengelhaupt Intellectual Property Attorneys Patentanwaltskanzlei PartGmbB
(86) International application number: PCT/CN2024/075286
(87) International publication number: WO 2024/169642

(57) **Abstract**

Disclosed in the present application are a heat dissipation device and an electronic device. The heat dissipation device comprises a shell, a support column, a first capillary structure, a second capillary structure, and a liquid return structure, wherein the shell comprises an upper shell and a lower shell, a sealed steam chamber is formed between the upper shell and the lower shell and is filled with a working medium liquid, and a mounting portion is formed on the lower shell and is in contact with an external heat source; the first capillary structure is arranged in the steam chamber and fitted to the upper shell; the second capillary structure is arranged in the steam chamber and fitted to the lower shell, the region of the second capillary structure corresponding to the mounting portion is a core evaporation region, and the side of the core evaporation region that faces the first capillary structure is provided with a steam flow channel; one end of the support column is connected to the upper shell, and the other end of the support column is connected to the lower shell; and the liquid return structure is connected between the first capillary structure and the second capillary structure.

## Description

### CROSS-REFERENCE TO RELATED APPLICATIONS

The present application claims priority to Chinese Application No. 202310106348.8, filed on February 13, 2023, the disclosure of which is hereby incorporated by reference in its entirety.

### TECHNICAL FIELD

The present application relates to the technical field of heat dissipation of electronic equipment, and in particular to a heat dissipation device and an electronic equipment.

### BACKGROUND

With the rapid development of the communications and electronics industry, larger capacity and higher performance are the development direction of electronic products. As a result, the degree of equipment integration becomes increasingly higher, and the power consumption of devices continues to grow significantly, especially for some multifunctional chips, which has increasingly higher integration, resulting in a continuous increase in heat flux density, which poses a severe challenge to heat dissipation technology. At present, a vapor chamber (VC) is usually used for heat dissipation, the normal operation of the vapor chamber is restricted by the capillary limit, and it is easy for the liquid working fluid in the capillary structure of the evaporation region to evaporate and dry up without timely replenishment, resulting in dry burning of the capillary structure, which in turn leads to failure of the vapor chamber. Or because the capillary structure is too thick or the amount of liquid injected is excessive, the evaporation thermal resistance is too large, so that the performance of the VC does not meet the heat dissipation requirements.

### SUMMARY

The main purpose of the present application is to provide a heat dissipation device and electronic equipment, aiming to solve the problem of failure of the vapor chamber caused by dry burning of its capillary structure and low heat dissipation efficiency caused by excessive evaporation thermal resistance.

To achieve the above purpose, the present application proposes a heat dissipation device, comprising a shell, a support column, a first capillary structure, a second capillary structure and a liquid return structure, wherein the shell comprises an upper shell and a lower shell, a sealed steam chamber is formed between the upper shell and the lower shell and is filled with working medium liquid, and a mounting portion is formed on the lower shell and is in contact with an external heat source; the first capillary structure is arranged in the steam chamber and attached to the upper shell; the second capillary structure is arranged in the steam chamber and attached to the lower shell, the region of the second capillary structure corresponding to the mounting portion is a core evaporation region, and the side of the core evaporation region that faces the first capillary structure is provided with a steam flow channel; one end of the support column passes through the first capillary structure and is connected to the upper shell, and the other end of the support column passes through the second capillary structure and is connected to the lower shell; the liquid return structure is connected between the first capillary structure and the second capillary structure, and there is an interval between the liquid return structure and the steam flow channel.

In addition, the present application also provides an electronic equipment, which comprises a heat source and the heat dissipation device as described above, and the heat source is in contact with the mounting portion.

### BRIEF DESCRIPTION OF DRAWINGS

In order to more clearly illustrate the technical solutions in the embodiments of the present application or the prior art, the drawings required for use in the embodiments or the prior art description will be briefly introduced below. Obviously, the drawings described below are only some embodiments of the present application. For those skilled in the art, other drawings can be obtained based on the structures shown in these drawings without creative work.
Fig. 1 is a cross-sectional structural diagram of the heat dissipation device in an embodiment of the present application from one perspective;
Fig. 2 is a cross-sectional structural diagram of the heat dissipation device in an embodiment of the present application from another perspective;
Fig. 3 is a structural diagram of the heat dissipation device in the first embodiment of the present application;
Fig. 4 is a structural diagram of the heat dissipation device in the second embodiment of the present application;
Fig. 5 is a structural diagram of the heat dissipation device in the third embodiment of the present application;
Fig. 6 is a structural diagram of the heat dissipation device in the fourth embodiment of the present application.

Description of the reference numerals:
100. heat dissipation device; 1. shell; 11. upper shell; 12. lower shell; 121. bottom plate; 122. side plate; 123. mounting portion; 13. steam chamber; 2. first capillary structure; 3. second capillary structure; 31. core evaporation region; 32. steam flow channel; 4. support column; 5. liquid return structure; 6. auxiliary liquid return structure; 200. heat source.

The realization of the purpose, functional features and advantages of the present application will be further explained in conjunction with the embodiments and with reference to the accompanying drawings.

### DETAILED DESCRIPTION

The following will be combined with the drawings in the embodiments of the present application to clearly and completely describe the technical solutions in the embodiments of the present application. Obviously, the described embodiments are only part of the embodiments of the present application, not all of them. Based on the embodiments in the present application, all other embodiments obtained by those skilled in the art without creative work are within the scope of protection of the present application.

It should be noted that all directional indications in the embodiments of the present application (such as up, down, left, right, front, back...) are only used to explain the relative position relationship, movement, etc. between the components under a specific posture (as shown in the drawings). If the specific posture changes, the directional indications will also change accordingly.

In addition, the descriptions of "first", "second", etc. in the present application are only for descriptive purposes, and cannot be understood as indicating or implying their relative importance or implicitly indicating the number of technical features indicated. Therefore, the features defined as "first" and "second" may explicitly or implicitly include at least one of the features. In the description of the present application, the meaning of "a plurality of' is at least two, such as two, three, etc., unless otherwise clearly and specifically defined.

In the present application, unless otherwise clearly specified and limited, the terms "connection", "fixation", etc. should be understood in a broad sense. For example, "fixation" can be a fixed connection, a detachable connection, or an integral connection; it can be a mechanical connection or an electrical connection; it can be a direct connection or an indirect connection through an intermediate medium, it can be the internal connection of two elements or the interaction relationship between two elements, unless otherwise clearly defined. For those skilled in the art, the specific meanings of the above terms in the present application can be understood according to the specific circumstances.

In addition, the technical solutions between the various embodiments of the present application can be combined with each other, but they must be based on what can be achieved by those skilled in the art. When the combination of technical solutions is contradictory or cannot be achieved, it should be considered that such a combination of technical solutions does not exist and is not within the scope of protection required by the present application.

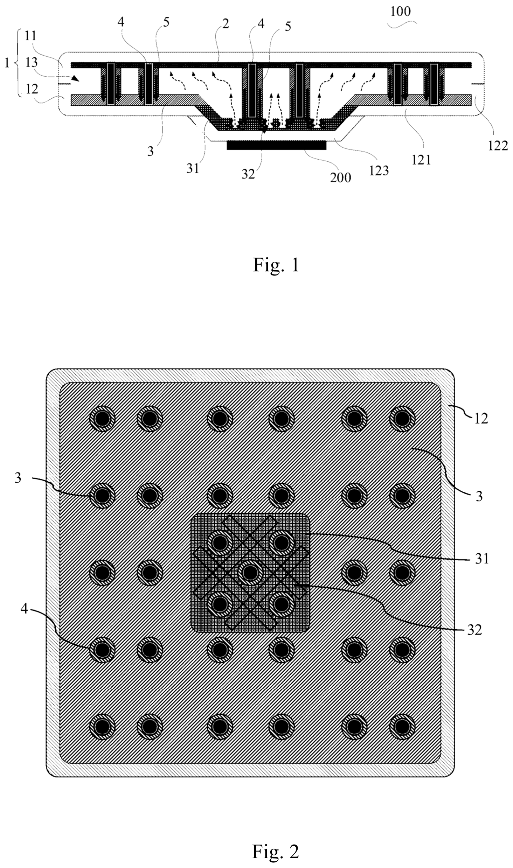

As shown in Figs. 1 to 3, in an embodiment of the present application, the heat dissipation device 100 comprises a shell 1, a support column 4, a first capillary structure 2, a second capillary structure 3 and a liquid return structure 5; the shell 1 comprises an upper shell 11 and a lower shell 12, a sealed steam chamber 13 is formed between the upper shell 11 and the lower shell 12, and a mounting portion 123 is formed on the lower shell 12 and is in contact with an external heat source; the first capillary structure 2 is arranged in the steam chamber 13 and attached to the upper shell 11; the second capillary structure 3 is arranged in the steam chamber 13 and attached to the lower shell 12, the region of the second capillary structure 3 corresponding to the mounting portion 123 is a core evaporation region 31, and the side of the core evaporation region 31 that faces the first capillary structure 2 is provided with a steam flow channel 32; one end of the support column 4 passes through the first capillary structure 2 and is connected to the upper shell 11, and the other end of the support column 4 passes through the second capillary structure 3 and is connected to the lower shell 12; the liquid return structure 5 is connected between the first capillary structure 2 and the second capillary structure 3, and there is an interval between the liquid return structure 5 and the steam flow channel 32.

In this embodiment, the steam chamber 13 in the shell 1 is evacuated, and the support column 4 is provided between the top and the bottom of the shell 1 to prevent the steam chamber 13 from collapsing. The steam chamber 13 is filled with working medium liquid, which may be water or acetone. The mounting portion 123 of the shell 1 is in contact with the heat source 200, which may be a chip or other high-power device. The heat source 200 generates heat when working, and the heat is conducted to the core evaporation region 31 of the second capillary structure 3 through the shell 1. The working medium liquid absorbs heat at the core evaporation region 31 of the second capillary structure 3 and evaporates on the surface of the liquid film, taking away the heat. Due to the existence of the steam flow channel 32, the thickness of the evaporation liquid film can be reduced, the evaporation surface area can be increased, and the thermal resistance can be reduced; the steam generated on the surface of the evaporation liquid film will preferentially overflow from the steam flow channel 32 with lower flow resistance, so that the steam flows in an orderly manner and reduces the contact with the reflux liquid in the liquid return structure 5 to a certain extent, reducing the shear force of the steam-liquid counterflow, making the liquid reflux path unobstructed, and effectively realizing the "steam-liquid separation" inside the heat dissipation device 100, so that the condensed working medium liquid can be refluxed in time and fully, effectively avoiding the occurrence of local dry burning inside the heat dissipation device 100. That is, by optimizing the design of the second capillary structure 3, the evaporation thermal resistance of the heat dissipation device 100 can be effectively reduced, the liquid reflux efficiency can be improved, and the temperature uniformity performance of the heat dissipation device 100 can be improved, so that the heat dissipation device 100 is suitable for application scenarios of high power consumption and high heat flux density chips.

The width of the steam flow channel 32 is 0.5mm to 5mm, thereby providing a sufficiently wide steam overflow path to ensure that the steam formed by the evaporation of the working medium liquid can smoothly enter the steam chamber 13; the depth of the steam channel 32 is 0.1mm to 0.9mm, thereby ensuring that there is a sufficient height difference between the bottom surface of the steam flow channel 32 and the upper surface of the second capillary structure 3, and the working medium gas formed by the evaporation of the working medium can overflow from the side wall of the steam flow channel 32 to the steam flow channel 32 and enter the steam chamber 13, thereby allowing the steam to flow in an orderly manner, making the reflux path of the working medium liquid unobstructed, and effectively realizing the "steam-liquid separation" inside the heat dissipation device 100; and compared with the traditional capillary structure, the effective evaporation surface area is increased, and the heat exchange speed is improved. In the actual implementation process, the width and depth of the steam flow channel 32 can be adjusted according to the size of the heat dissipation device 100 and the heating power of the heat source 200.

In one embodiment, the cross section of the steam flow channel 32 is arranged in equal diameter or an increasing manner in the direction toward the first capillary structure 2. By setting the cross section of the steam flow channel 32 to be gradually expanded, the resistance of the gas working medium in the process of overflowing upward from the steam flow channel 32 can be reduced, ensuring that the working medium liquid can quickly and smoothly enter the steam chamber 13 after evaporation. In other embodiments, the cross section of the steam flow channel 32 is arranged in equal diameter or non-equal diameter in the direction toward the first capillary structure 2, and it is only necessary to ensure that the flow channel is a groove structure opening toward the first capillary structure 2. For example, the cross section of the steam flow channel 32 can be semicircular, rectangular, triangular, polygonal, streamlined, etc.

In one embodiment, a plurality of liquid return structures 5 are correspondingly arranged inside the core evaporation region 31, and the plurality of liquid return structures 5 are arranged at intervals, and the steam flow channel 32 is arranged between any two adjacent liquid return structures 5. Since the mounting portion 123 is in direct contact with the heat source 200, correspondingly, the core evaporation region 31 of the second capillary structure 3 is rapidly heat exchanged and evaporated, and after condensation in the first capillary structure 2, the evaporated working medium liquid is condensed and concentratedly refluxed to the core evaporation region 31 by setting the plurality of liquid return structures 5, so as to avoid dry burning in the core evaporation region 31; and a steam flow channel 32 is arranged between any two adjacent liquid return structures 5, that is, the steam flow channel 32 is evenly distributed in the core evaporation region 31, and the working medium liquid that flows back to the core evaporation region 31 through the liquid return structure 5 and heat exchanges and evaporates again to form a working medium gas that can diffuse and overflow to the steam flow channel 32, thereby accelerating the heat exchange cycle and improving the heat exchange efficiency.

In addition, a plurality of liquid return structures 5 are correspondingly arranged outside the core evaporation region 31, and the density of the liquid return structures 5 correspondingly arranged inside the core evaporation region 31 is greater than the density of the liquid return structures 5 correspondingly arranged outside the core evaporation region 31, wherein the density of the liquid return structures 5 refers to the number of liquid return structures 5 per unit area, and the region outside the core evaporation region 31 is defined as the peripheral region. It can be understood that since the working medium liquid forms steam after evaporation and diffuses freely in the steam chamber, it is inevitable that the steam condenses in the first capillary structure 2 corresponding to the peripheral region. By also correspondingly arranging a plurality of liquid return structures 5 outside the core evaporation region 31 to assist in reflux to the second capillary structure 3 in the peripheral region, the working medium liquid in the entire second capillary structure 3 can circulate with each other; thereby avoiding the condensed working medium liquid from concentrating at the core evaporation region 31 for reflux, and ensuring the reflux efficiency, it is only necessary to ensure that the reflux efficiency at the core evaporation region 31 is greater than the reflux efficiency at the peripheral region.

In one embodiment, the heat dissipation device 100 further comprises an auxiliary liquid return structure 6, which is connected between the first capillary structure 2 and the second capillary structure 3. The auxiliary liquid return structures 6 are arranged at the intervals between the plurality of liquid return structures 5 correspondingly arranged in the core evaporation region 31. The auxiliary liquid return structure 6 is also used for the working medium liquid condensed in the first capillary structure 2 to flow back to the second capillary structure 3. The auxiliary liquid return structure 6 and the liquid return structure 5 differ only in size or shape, and the auxiliary liquid return structure 6 can further increase the reflux efficiency of working medium liquid in the core evaporation region 31. Correspondingly, the second capillary structure 3 is also provided with a steam flow channel 32 at a position corresponding to the outer periphery of the auxiliary liquid return structure 6, or a steam flow channel 32 exists between the auxiliary liquid return structure 6 and the adjacent liquid return structure 5/auxiliary liquid return structure 6, so as to further increase the effective evaporation surface area, improve the liquid reflux efficiency, and thus further improve the evaporation efficiency.

The first capillary structure 2 is at least one of sintered copper powder, copper mesh, grooves, and fibers; the second capillary structure 3 is at least one of sintered copper powder, copper mesh, grooves, and fibers; the liquid return structure 5 is at least one of sintered copper powder, copper mesh, grooves, and fibers. The first capillary structure 2, the second capillary structure 3, and the liquid return structure 5 can all adopt a porous structure with capillary function in the prior art, such as sintered copper powder, copper mesh, grooves, and fibers. For example, copper powder can be used to make a paste or slurry, and then screen printing or extrusion can be used to manufacture capillary structures of various shapes and thicknesses, and sintering at a temperature above 850 degrees Celsius to ensure structural strength. Or it can be a grid structure formed by weaving multiple metal wires, or a layer of metal powder can be sintered on the surface of the grid structure. The first capillary structure 2 is connected to the upper shell 11 by sintering, CNC, etching or other processes, and the second capillary structure 3 is connected to the lower shell 12 by sintering, CNC, etching or other processes.

In one embodiment, the liquid return structure 5 is wrapped around the periphery of the support column 4, and the liquid return structure 5 is tightly attached to the support column 4. The support column 4 is used to prevent the chamber between the upper shell 11 and the lower shell 12 from being sunken, and the support column 4 provides an attachment surface during sintering, which can ensure that the liquid return structure 5 adheres to the support column 4, and prevents the liquid return structure 5 from being deformed and affecting the liquid return function.

In one embodiment, the edge of the upper shell 11 and the edge of the lower shell 12 are welded to form a steam chamber 13. For easy installation, the liquid return structure 5, the first capillary structure 2 and the second capillary structure 3 are arranged first, and finally the upper shell 11 and the lower shell 12 are assembled to form the heat dissipation device 100. The upper shell 11 and the lower shell 12 are welded to ensure the sealing performance, avoid the working medium liquid in the steam chamber 13 from evaporating and overflowing, and ensure the performance and service life of the heat dissipation device 100. The upper shell 11 and the lower shell 12 form a sealed chamber by diffusion welding, brazing, laser welding or other welding processes.

The bottom plate 121 of the lower shell 12 protrudes in a direction away from the first capillary structure 2 to form the mounting portion 123, and the protruding size of the mounting portion 12 matches the height of the heat source 200; that is, the middle region of the bottom of the lower shell 12 has a mounting portion 123 protruding outward, and the protruding size of the mounting portion 123 matches the height of the heat source 200, and other devices around the heat source 200 are effectively avoided while ensuring that the mounting portion 123 is in contact with the heat source 200. When the top of the heat source 200 is higher than other surrounding devices, the mounting portion 123 and the bottom form a complete flat plate structure, and there is no need to design a protruding mounting portion 123 for avoidance.

The lower shell 12 comprises a bottom plate 121, a side plate 122 and a mounting portion 123, the side plate 122 is connected to the edge of the bottom plate 121, and the side plate 122 is sealed to the edge of the upper shell 11. The upper shell 11 can be a flat plate structure or can be provided with a side plate structure. The lower shell 12 is an integral structure formed in single piece, that is, the lower shell 12 is formed by machining, stamping or other processes to form the side plate and the mounting portion. Similarly, the upper shell 11 is also an integral structure formed in single piece, and the upper shell 11 and the lower shell 12 are welded to form a sealed steam chamber. The upper shell 11 and the lower shell 12 are both made of metal, alloy, composite material or other high thermal conductivity materials to ensure that the working medium liquid in the second capillary structure 3 can quickly exchange heat, and at the same time ensure that the working medium liquid steam can quickly condense in the first capillary structure 2.

Usually, a nozzle (not marked) is provided on the upper shell 11 or the lower shell 12, and the nozzle is used for vacuuming and filling the working medium liquid. After vacuuming, the nozzle is sealed, and a steam chamber 13 is formed between the upper shell 11 and the lower shell 12. In order to prevent the chamber between the upper shell 11 and the lower shell 12 from being sunken, a support column 4 is provided between the upper shell 11 and the lower shell 12. On the premise of ensuring the structural strength of the heat dissipation device 100, the diameter and number of the support column 4 can be flexibly optimized and designed, and correspondingly, the structural shapes of the second capillary structure 3 and the steam flow channel 32 are different.

The following four embodiments illustrate the arrangement scheme of the steam flow channel 32 of the present application.

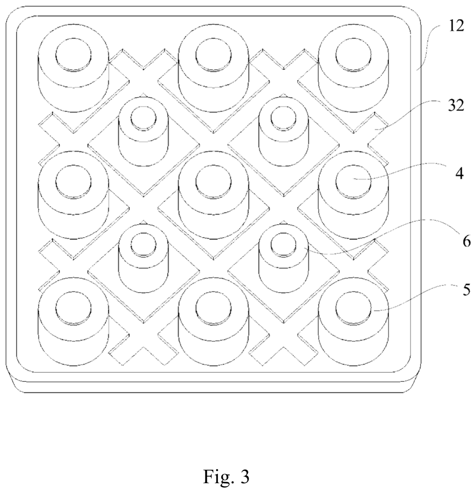

The technical solution of the first embodiment is shown in Figs. 2 and 3. The support columns 4 are distributed in matrix, and a liquid return structure 5 is arranged on the side of each support column 4. One auxiliary liquid return structure 6 is arranged at the center position of each matrix of 2×2 support columns 4. The steam flow channels 32 are cross-arranged to form a grid structure arranged in a "cross" shape. A liquid return structure 5 or an auxiliary liquid return structure 6 is arranged at each mesh hole, thereby ensuring that the steam flow channel 32 surrounds the periphery of the liquid return structure 5, and the steam flow channel 32 also surrounds the periphery of the auxiliary liquid return structure 6, thereby providing sufficient steam convergence flow space.

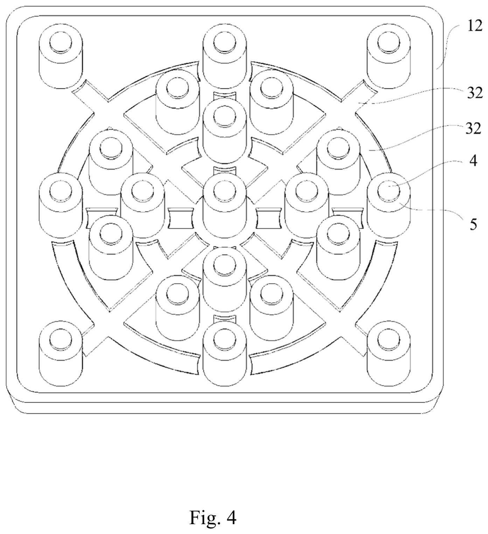

The technical solution of the second embodiment is shown in Fig. 4, the steam flow channel 32 comprises a plurality of first steam flow channels arranged in concentric circles and a plurality of second steam flow channels arranged in radial shape, the first steam flow channels and the second steam flow channels form a spider web structure, part of the liquid return structures 5 are arranged at the mesh holes of the spider web structure, and part of the liquid return structures 5 are arranged at intervals along the extension direction of the first steam flow channel and divide the first steam flow channels into a plurality of arc segments, and the remaining liquid return structures are arranged at intervals along the extension direction of the second steam flow channels and divide the second steam flow channels into a plurality of straight segments. As a result, the steam flow channels are arranged in a denser configuration within the central region, thereby further enhancing the heat dissipation effect of the central region.

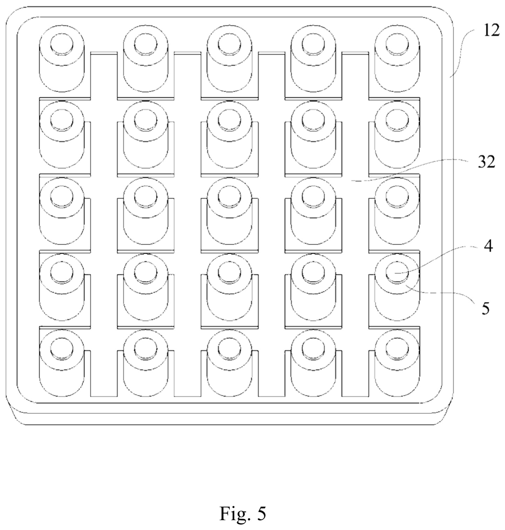

The technical solution of the third embodiment is shown in Fig. 5. The steam flow channels 32 are arranged in a " 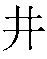 " shape to form a grid structure. The liquid return structures 5 are arranged at each mesh hole, that is, the support columns 4 are arranged in matrix. The steam flow channels 32 are arranged between any two adjacent rows of liquid return structures 5 or between any two adjacent columns of liquid return structures 5, so that the steam flow channel 32 surrounds the periphery of the liquid return structures 5 to provide sufficient steam convergence flow space.

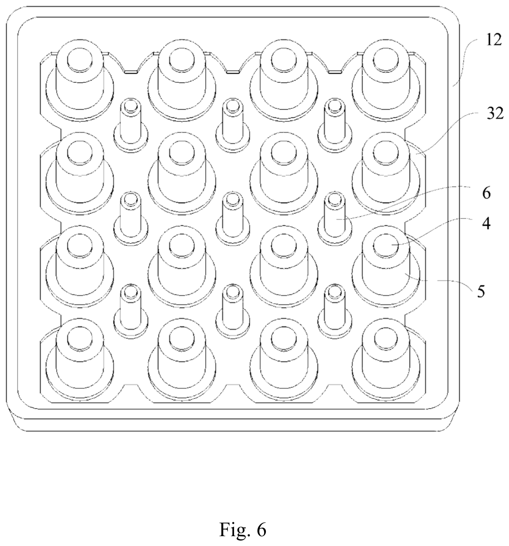

The technical solution of the fourth embodiment is shown in Fig. 6. The support columns 4 are arranged in matrix, and the liquid return structures 5 are also arranged in matrix. The number of steam flow channels 32 is consistent with that of liquid return structures 5 and they are arranged in a one-to-one correspondence configuration at the periphery of the liquid return structures 5; one auxiliary liquid return structure 6 is arranged at the center position of each matrix of 2×2 support columns 4, and annular steam flow channels 32 are arranged at the periphery of the liquid return structures 5 and the auxiliary liquid return structures 6. Adjacent annular steam flow channels 32 are interconnected to provide sufficient steam convergence flow space.

In addition, the present application also provides an electronic equipment, the electronic equipment comprises a heat source 200 and the heat dissipation device 100 as described above, and the heat source 200 is in contact with the mounting portion 123. Since the electronic equipment comprises the heat dissipation device 100 as described above, the electronic equipment has all the beneficial effects of the heat dissipation device 100, which will not be described one by one here.

The above description is only some embodiments of the present application, and does not limit the scope of the present application. All equivalent structural changes made by using the contents of the present application specification and drawings under the inventive concept of the present application, or directly/indirectly used in other related technical fields are included in the protection scope of the present application.

## Claims

1. A heat dissipation device, comprising:
a shell, where the shell comprises an upper shell and a lower shell, a sealed steam chamber is formed between the upper shell and the lower shell and is filled with working medium liquid, and a mounting portion is formed on the lower shell and is in contact with an external heat source;
a first capillary structure, where the first capillary structure is arranged in the steam chamber and attached to the upper shell;
a second capillary structure, where the second capillary structure is arranged in the steam chamber and attached to the lower shell, an region of the second capillary structure corresponding to the mounting portion is a core evaporation region, and a side of the core evaporation region that faces the first capillary structure is provided with a steam flow channel;
a support column, where one end of the support column passes through the first capillary structure and is connected to the upper shell, and the other end of the support column passes through the second capillary structure and is connected to the lower shell;
a liquid return structure, where the liquid return structure is connected between the first capillary structure and the second capillary structure, and there is an interval between the liquid return structure and the steam flow channel.

2. The heat dissipation device according to claim 1, wherein a plurality of the liquid return structures are correspondingly arranged inside the core evaporation region, the plurality of the liquid return structures are arranged at intervals, and the steam flow channel is arranged between any two adjacent liquid return structures.

3. The heat dissipation device according to claim 2, wherein a plurality of the liquid return structures are correspondingly arranged outside the core evaporation region, and a density of the liquid return structures correspondingly arranged inside the core evaporation region is greater than a density of the liquid return structures correspondingly arranged outside the core evaporation region.

4. The heat dissipation device according to claim 2, wherein the heat dissipation device further comprises an auxiliary liquid return structure, the auxiliary liquid return structure is connected between the first capillary structure and the second capillary structure, and the auxiliary liquid return structure is arranged at the interval between the plurality of liquid return structures arranged correspondingly in the core evaporation region.

5. The heat dissipation device according to claim 1, wherein a width of the steam flow channel is 0.5 mm to 5 mm, and a depth of the steam flow channel is 0.1 mm to 0.9 mm.

6. The heat dissipation device according to claim 1, wherein a cross section of the steam flow channel is arranged in equal diameter or in an increasing manner in the direction toward the first capillary structure.

7. The heat dissipation device according to claim 1, wherein the first capillary structure is at least one of sintered copper powder, copper mesh, groove, and fiber; and/or the second capillary structure is at least one of sintered copper powder, copper mesh, groove, and fiber; and/or the liquid return structure is at least one of sintered copper powder, copper mesh, groove, and fiber.

8. The heat dissipation device according to any one of claims 1-7, wherein the liquid return structure is wrapped around the periphery of the support column, and the liquid return structure is tightly attached to the support column.

9. The heat dissipation device according to any one of claims 1-7, wherein the steam channels are arranged crosswise to form a grid structure, and the liquid return structures are located at mesh holes of the grid structure; or,
the steam flow channels comprise a plurality of first steam channels arranged in concentric circles and a plurality of second steam channels arranged in radial shape, the first steam flow channels and the second steam flow channels form a spider web structure, part of the liquid return structures are arranged at mesh holes of the spider web structure, and part of the liquid return structures are arranged at intervals along the extension direction of the first steam flow channels and divide the first steam channels into a plurality of arc segments, and the remaining liquid return structures are arranged at intervals along the extension direction of the second steam channels and divide the second steam channels into a plurality of straight segments; or,
the liquid return structures are arranged in matrix, and the steam flow channel is arranged between any two adjacent rows of the liquid return structures or between any two adjacent columns of the liquid return structures; or,
the liquid return structures are arranged in matrix, and the number of the steam flow channels is consistent with that of the liquid return structures and they are arranged in a one-to-one correspondence configuration at the periphery of the liquid return structures.

10. The heat dissipation device according to any one of claims 1-7, wherein a bottom plate of the lower shell protrudes in a direction away from the first capillary structure to form the mounting portion, and the protruding size of the mounting portion matches a height of the heat source.

11. An electronic equipment, comprising a heat source and the heat dissipation device according to any one of claims 1 to 10, and the heat source is in contact with the mounting portion.
